# EUROPEAN PATENT APPLICATION

(11) **EP 4 426 086 A2**
(43) Date of publication of application: **04.09.2024**
(21) Application number: 24160103.8
(22) Date of filing: 27.02.2024
(51) Int. Cl.: H10K 59/124, H10K 59/126, H10K 59/131, H10K 59/35, H10K 59/80

(54) **DISPLAY APPARATUS**

(30) Priority: 28.02.2023 KR 20230026907
(71) Applicant: Samsung Display Co., Ltd., Yongin-si, Gyeonggi-do 17113 (KR)
(72) Inventor: LEE, Wonse, 17113 Yongin-si (KR); KIM, Jongseok, 17113 Yongin-si (KR); LEE, Sujin, 17113 Yongin-si (KR); JANG, Donghyeon, 17113 Yongin-si (KR)
(74) Representative: Marks & Clerk LLP

(57) **Abstract**

Provided is a display apparatus. The display apparatus includes a first display area in which first light-emitting diodes are arranged, a second display area at least partially surrounded by the first display area in plan view, and in which display element groups including second light-emitting diodes and transmission areas are arranged, at least one of the transmission areas having a circular shape, a light-blocking insulating layer defining emission areas of the first light-emitting diodes and the second light-emitting diodes, and an anti-reflection layer above the light-blocking insulating layer, and including a light-blocking layer and color filters, wherein one or more of the transmission areas are defined in plan view by a circular opening defined by at least one of the light-blocking layer or the light-blocking insulating layer.

## Description

### BACKGROUND

### 1. Field

One or more embodiments relate to a display apparatus.

### 2. Description of the Related Art

Mobility-based electronic devices are widely used. Recently, tablet personal computers (PCs), in addition to small electronic devices, such as mobile phones, have become widely used as mobile electronic devices.

A mobile electronic device includes a display apparatus for providing visual information, such as an image to a user, to support various functions. Recently, as other components for driving a display apparatus have been miniaturized, the proportion of the display apparatus in an electronic device has gradually increased, and a structure that is bendable from a flat state to have a certain angle has been developed.

### SUMMARY

A display apparatus includes a component configured to scatter light that is incident thereon. In this case, because light detected by the component is not clear, a distorted image may be detected by the component. One or more embodiments include a display apparatus capable of detecting a clear image.

Additional aspects will be set forth in part in the description that follows and, in part, will be apparent from the description, or may be learned by practice of the presented embodiments.

According to one or more embodiments, a display apparatus includes a first display area in which first light-emitting diodes are arranged, a second display area at least partially surrounded by the first display area in plan view, and in which display element groups including second light-emitting diodes and transmission areas are arranged, at least one of the transmission areas having a circular shape, a light-blocking insulating layer defining emission areas of the first light-emitting diodes and the second light-emitting diodes, and an anti-reflection layer above the light-blocking insulating layer, and including a light-blocking layer and color filters, wherein one or more of the transmission areas are defined in plan view by a circular opening defined by at least one of the light-blocking layer or the light-blocking insulating layer.

The display apparatus may further include a blocking metal layer in the second display area.

The blocking metal layer may define an opening corresponding to each transmission area.

The opening may have a circular shape in plan view.

The display apparatus may further include a first horizontal wiring crossing the first display area, and extending from the first display area to the second display area, and a second horizontal wiring spaced from the first horizontal wiring, crossing the first display area, and extending from the first display area to the second display area, wherein a width of a part of the second horizontal wiring is greater than a width of a part of the first horizontal wiring in plan view.

The first horizontal wiring may be electrically connected to a pixel circuit of at least one of the first light-emitting diodes and to a pixel circuit of at least one of the second light-emitting diodes.

The second horizontal wiring may include a first wiring portion extending in a first direction, and a second wiring portion extending diagonally with respect to the first direction, wherein a width of the first wiring portion is less than a width of the second wiring portion in plan view.

The first horizontal wiring and the second horizontal wiring may be respectively at different layers.

A total resistance of the first horizontal wiring may be substantially similar to a total resistance of the second horizontal wiring.

A width of the first horizontal wiring may be substantially constant in plan view.

The second horizontal wiring may be connected to a pixel circuit of at least one of the first light-emitting diodes.

According to one or more embodiments, a display apparatus includes a first display area in which first light-emitting diodes are arranged, a second display area at least partially surrounded by the first display area, and in which display element groups including second light-emitting diodes and transmission areas are arranged, at least one of the transmission areas having a circular shape, a light-blocking insulating layer configured to define emission areas of the first light-emitting diodes and the second light-emitting diodes, an anti-reflection layer above the light-blocking insulating layer, and including a light-blocking layer and color filters, a first horizontal wiring crossing the first display area, and extending from the first display area to the second display area, and a second horizontal wiring spaced apart from the first horizontal wiring, crossing the first display area, and extending from the display area to the second display area, wherein a width of the second horizontal wiring varies in plan view, and wherein a width of a part of the second horizontal wiring is greater than a width of a part of the first horizontal wiring in plan view.

The first horizontal wiring may be electrically connected to a pixel circuit of at least one of the first light-emitting diodes, and to a pixel circuit of at least one of the second light-emitting diodes.

The second horizontal wiring may include a first wiring portion extending in a first direction, and a second wiring portion extending diagonally with respect to the first direction, wherein a width of the first wiring portion is less than a width of the second wiring portion in plan view.

The first horizontal wiring and the second horizontal wiring may be respectively at different layers.

A total resistance of the first horizontal wiring may be substantially similar to a total resistance of the second horizontal wiring.

A width of the first horizontal wiring may be constant in plan view.

The second horizontal wiring may be connected to a pixel circuit of at least one of the first light-emitting diodes.

The display apparatus may further include a blocking metal layer in the second display area, and defining openings corresponding to the transmission areas.

The opening may have a circular shape in plan view.

At least some of the above and other features of the invention are set out in the claims.

Other aspects of the disclosure will become more apparent from the drawings, the claims, and the detailed description.

These general and specific embodiments may be implemented by using a system, a method, a computer program, or a combination thereof.

### BRIEF DESCRIPTION OF THE DRAWINGS

The above and other aspects of certain embodiments will be more apparent from the following description taken in conjunction with the accompanying drawings, in which:
FIG. 1 is a perspective view illustrating an electronic device, according to one or more embodiments;
FIGS. 2A and 2B are perspective views illustrating a foldable electronic device, and respectively illustrate a folded state and an unfolded state of the foldable electronic device, according to one or more embodiments;
FIG. 3 is a plan view schematically illustrating an electronic device, according to one or more embodiments;
FIG. 4 is a cross-sectional view illustrating a part of an electronic device, according to one or more embodiments;
FIG. 5 is an equivalent circuit diagram schematically illustrating a pixel circuit electrically connected to a light-emitting diode of a display apparatus, according to one or more embodiments;
FIG. 6 is a plan view illustrating a part of a first display area of a display apparatus, according to one or more embodiments;
FIGS. 7A and 7B are plan views illustrating a part of a second display area of a display apparatus, according to one or more embodiments;
FIG. 7C is a plan view schematically illustrating a pixel group of a second display area of a display apparatus, according to one or more embodiments;
FIG. 8 is a plan view illustrating a second display area and a first display area around the second display area in a display apparatus, according to one or more embodiments;
FIG. 9 is a cross-sectional view taken along the line A-A' of FIG. 8;
FIG. 10A is a cross-sectional view taken along the line B-B' of FIG. 8;
FIG. 10B is a plan view schematically illustrating positions of openings of FIG. 10A;
FIG. 11A is a plan view schematically illustrating a horizontal wiring and a transmission area of FIG. 8;
FIG. 11B is a cross-sectional view taken along the line D-D' of FIG. 11A;
FIG. 12A is a cross-sectional view schematically illustrating a part of a display apparatus, according to one or more other embodiments; and
FIG. 12B is a plan view schematically illustrating positions of openings of FIG. 12A.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments of the present disclosure may be combined or combined with each other, in part or in whole, and technically various interlocking and driving are possible. Each embodiment may be implemented independently of each other or may be implemented together in an association. The described embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

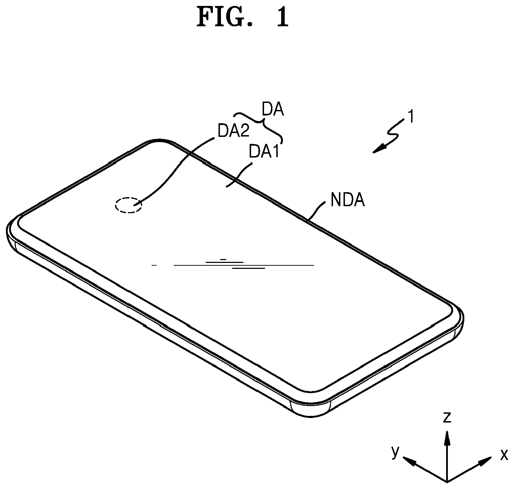

FIG. 1 is a perspective view illustrating an electronic device, according to one or more embodiments.

According to one or more embodiments, an electronic device 1 for displaying a moving image or a still image may be used as a display screen of not only a portable electronic device, such as a mobile phone, a smartphone, a tablet personal computer (PC), a mobile communication terminal, an electronic organizer, an electronic book, a portable multimedia player (PMP), a navigation device, or an ultra-mobile PC (UMPC), but also any of various products, such as a television, a laptop computer, a monitor, an advertisement board, or an Internet of things (IoT) product. Also, the electronic device 1 according to one or more embodiments may be applied to a wearable device, such as a smart watch, a watch phone, a glasses-type display, or a head-mounted display (HMD). Also, the electronic device 1 according to one or more embodiments may be used as a center information display (CID) located on an instrument panel, a center fascia, or a dashboard of a vehicle, a room mirror display replacing a side-view mirror of a vehicle, or a display located on the back of a front seat for entertainment of a rear seat passenger of a vehicle. For convenience of explanation, the electronic device 1 is a smartphone in FIG. 1.

Referring to FIG. 1, the electronic device 1 may include a display area DA, and a non-display area NDA outside the display area DA. The electronic device 1 may provide an image through an array of pixels that are two-dimensionally arranged in the display area DA.

The non-display area NDA where an image is not provided may entirely surround the display area DA (e.g., in plan view). A driver or the like for applying an electrical signal or power to display elements located in the display area DA may be located in the non-display area NDA. A pad to which an electronic element or a printed circuit board may be electrically connected may be located in the non-display area NDA.

The display area DA may include a first display area DA1 and a second display area DA2. The second display area DA2, where a component for adding various functions to the electronic device 1 is located, may correspond to a component area.

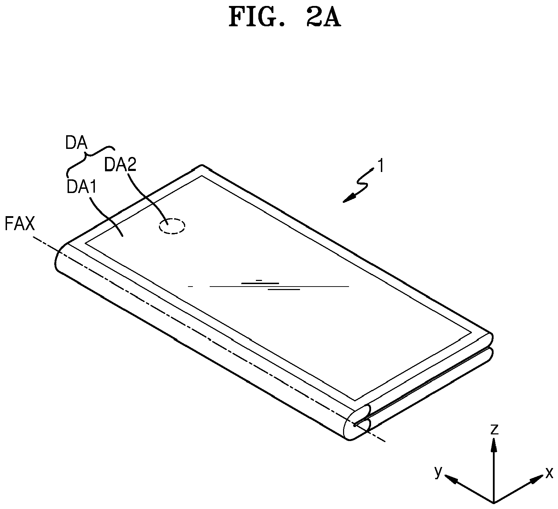

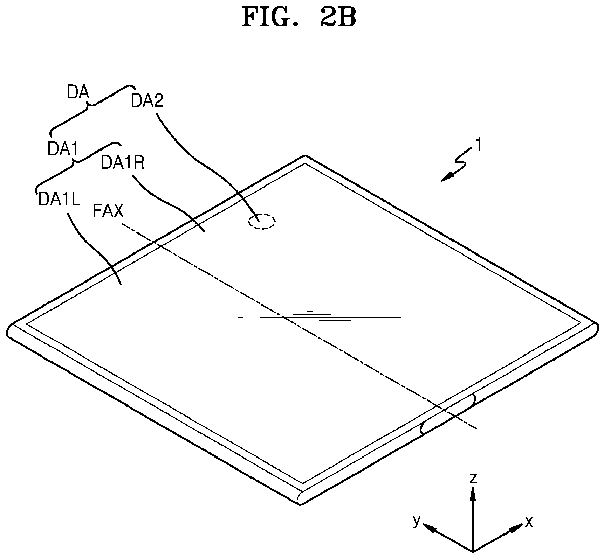

FIGS. 2A and 2B are perspective views illustrating a foldable electronic device, and respectively illustrate a folded state and an unfolded state of the foldable electronic device, according to one or more embodiments.

The electronic device 1 according to one or more embodiments may be a foldable electronic device. The electronic device 1 may be folded about a folding axis FAX. The display area DA may be located on an outer surface and/or an inner surface of the electronic device 1. In one or more embodiments, FIGS. 2A and 2B respectively illustrate that the display area DA is located on an outer surface and on an inner surface of the electronic device 1.

Referring to FIG. 2A, the display area DA may be located on an outer surface of the electronic device 1. The outer surface of the folded electronic device 1 may include the display area DA, and the display area DA may include the first display area DA1 occupying most of the display area DA, and the second display area DA2 having a smaller area than the first display area DA1.

Referring to FIG. 2B, the display area DA may be located on an inner surface of the electronic device 1. The inner surface of the unfolded electronic device 1 may include the display area DA, and the display area DA may include the first display area DA1 occupying most of the display area DA, and the second display area DA2 having a smaller area than the first display area DA1.

Although the first display area DA1 includes a left display area DA1L and a right display area DA1R located on respective sides of the folding axis FAX, and although the second display area DA2 is located in the right display area DA1R in FIG. 2B, the disclosure is not limited thereto. In one or more other embodiments, the second display area DA2 may be located in the left display area DA1L.

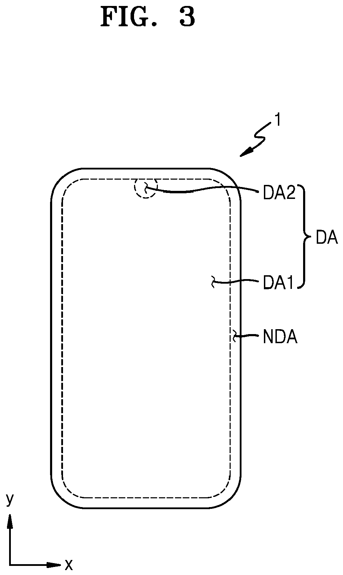

Although the second display area DA2 is entirely surrounded by the first display area DA1 in FIGS. 1, 2A, and 2B, the disclosure is not limited thereto. FIG. 3 is a plan view schematically illustrating an electronic device, according to one or more embodiments. As shown in FIG. 3, the second display area DA2 may be only partially surrounded by the first display area DA1 (e.g., in plan view).

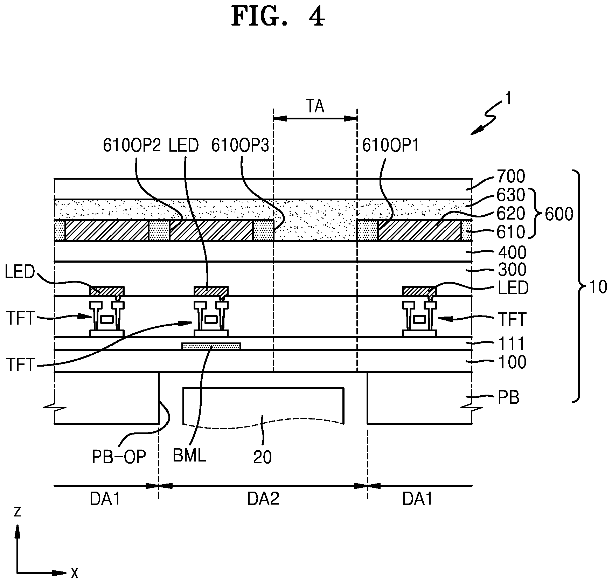

FIG. 4 is a cross-sectional view illustrating a part of an electronic device, according to one or more embodiments.

Referring to FIG. 4, the electronic device 1 may include a display apparatus 10, and a component 20 located on, or below, a bottom surface of the display apparatus 10 to overlap the display apparatus 10. The component 20 may be located in the second display area DA2.

The display apparatus 10 may include a substrate 100, a thin-film transistor TFT located on the substrate 100, a display element (e.g., a light-emitting diode (LED)) electrically connected to the thin-film transistor TFT, an encapsulation layer 300 covering the display element, an input sensing layer 400, an anti-reflection layer 600, and a window 700.

The substrate 100 may include glass or a polymer resin. The substrate 100 including the polymer resin may be flexible, foldable, rollable, or bendable. The substrate 100 may have a multi-layer structure including a layer including the polymer resin and an inorganic layer.

A lower protective film PB may be located on, or below, a bottom surface of the substrate 100. The lower protective film PB may be attached to the bottom surface of the substrate 100. An adhesive layer may be located between the lower protective film PB and the substrate 100. Alternatively, the lower protective film PB may be directly formed on the bottom surface of the substrate 100, and in this case, the adhesive layer is not located between the lower protective film PB and the substrate 100.

The lower protective film PB may support and protect the substrate 100. The lower protective film PB may have, or define, an opening PB-OP corresponding to the second display area DA2. The lower protective film PB may include an organic insulating material, such as polyethylene terephthalate (PET) or polyimide (PI).

The thin-film transistor TFT and the light-emitting diode LED, which is a display element electrically connected to the thin-film transistor TFT, may be located on a top surface of the substrate 100. The light-emitting diode LED may be an organic light-emitting diode including an organic material. The organic light-emitting diode may emit red light, green light, or blue light.

The light-emitting diode LED may be an inorganic light-emitting diode including an inorganic material. The inorganic light-emitting diode may include a PN junction diode including inorganic semiconductor-based materials. When a voltage is applied to a PN junction diode in a forward direction, holes and electrons may be injected, and energy generated by recombination of the holes and electrons may be converted into light energy to emit light of a corresponding color. The inorganic light-emitting diode may have a width of several to hundreds of micrometers, or several to hundreds of nanometers. In some embodiments, the light-emitting diode LED may include a quantum-dot light-emitting diode. An emission layer of the light-emitting diode LED may include an organic material, may include an inorganic material, may include quantum dots, may include an organic material and quantum dots, or may include an inorganic material and quantum dots.

The light-emitting diode LED may be electrically connected to the thin-film transistor TFT located under the light-emitting diode LED. In this regard, in FIG. 4, a buffer layer 111 is located on the substrate 100, and the thin-film transistor TFT is located on the buffer layer 111. The thin-film transistor TFT and the light-emitting diode LED electrically connected to the thin-film transistor TFT may be located in each of the first display area DA1 and the second display area DA2.

A transmission area TA may be located in the second display area DA2. The transmission area TA is an area through which light emitted from the component 20, and/or light emitted toward the component 20, may be transmitted. In the display apparatus 10, a transmittance of the transmission area TA may be about 30% or more, about 40% or more, about 50% or more, about 60% or more, about 70% or more, about 75% or more, about 80% or more, about 85% or more, or about 90% or more.

The component 20 may include a sensor, such as a proximity sensor, an ambient light sensor, an iris sensor, or a face recognition sensor, and/or a camera (or an image sensor). The component 20 may use light. For example, the component 20 may emit and/or receive light in infrared, ultraviolet, and/or visible bands. The proximity sensor using infrared rays may detect an object located close to a top surface of the electronic device 1, and the ambient light sensor may detect a brightness of light incident on the top surface of the electronic device 1. Also, the iris sensor may capture an image of an iris of a person located on the top surface of the electronic device 1, and the camera may receive light from the object located on the top surface of the electronic device 1.

To reduce or prevent the likelihood of a function of the thin-film transistor TFT located in the second display area DA2 from being degraded by light passing through the transmission area TA, a blocking metal layer BML may be located between the substrate 100 and the buffer layer 111. The blocking metal layer BML may be omitted from the first display area DA1. The blocking metal layer BML may be located in the second display area DA2, and may include/define an opening overlapping the transmission area TA.

The encapsulation layer 300 may cover the light-emitting diodes LED. The encapsulation layer 300 may include at least one inorganic encapsulation layer and at least one organic encapsulation layer. The encapsulation layer 300 may include first and second inorganic encapsulation layers 310 and 330, and an organic encapsulation layer 320 between the first and second inorganic encapsulation layers 310 and 330.

The input sensing layer 400 may be formed on the encapsulation layer 300. The input sensing layer 400 may obtain coordinate information according to an external input, for example, a touch event of an object, such as a finger or a stylus pen. The input sensing layer 400 may include a touch electrode and trace lines connected to the touch electrode. The input sensing layer 400 may detect an external input by using a mutual capacitance method or a self-capacitance method.

The anti-reflection layer 600 may reduce a reflectance of light (external light) incident from the outside on the display apparatus 10. The anti-reflection layer 600 may include a light-blocking layer 610, color filters 620, and an overcoat layer 630. The light-blocking layer 610 may include a fourth opening 610OP1 overlapping the light-emitting diode LED of the first display area DA1, and a fifth opening 610OP2 overlapping the light-emitting diode LED of the second display area DA2, and the color filters 620 may be located in the fourth and fifth openings 610OP1 and 610OP2. The light-blocking layer 610 may include a sixth opening 610OP3 not overlapping the light-emitting diode LED. The sixth opening 610OP3 may be a portion corresponding to the transmission area TA, and a part of the overcoat layer 630 may be located in the sixth opening 610OP3.

The window 700 is located on the anti-reflection layer 600. The window 700 may be coupled to the anti-reflection layer 600 through an adhesive layer, such as an optically clear adhesive. The window 700 may include a glass material or a plastic material. The glass material may include ultra-thin glass. Examples of the plastic material may include polyethersulfone, polyacrylate, polyether imide, polyethylene naphthalate, polyethylene terephthalate, polyphenylene sulfide, polyarylate, polyimide, polycarbonate, and cellulose acetate propionate.

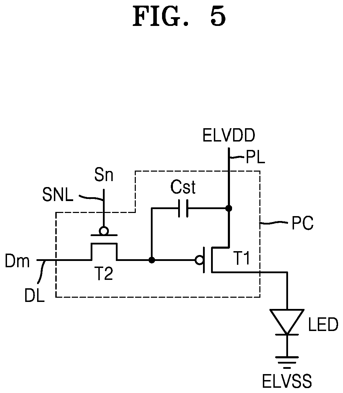

FIG. 5 is an equivalent circuit diagram schematically illustrating a pixel circuit electrically connected to a light-emitting diode of a display apparatus, according to one or more embodiments.

Referring to FIG. 5, a pixel circuit PC may include a first thin-film transistor T1, a second thin-film transistor T2, and a storage capacitor Cst.

The second thin-film transistor T2 that is a switching thin-film transistor may be connected to a scan line SNL and a data line DL, and may transmit a data voltage (or a data signal Dm) input from the data line DL to the first thin-film transistor T1 based on a switching voltage (or a switching signal Sn) input from the scan line SNL. The storage capacitor Cst may be connected to the second thin-film transistor T2 and a driving voltage line PL, and may store a voltage corresponding to a difference between a voltage received from the second thin-film transistor T2 and a first power supply voltage ELVDD supplied to the driving voltage line PL.

The first thin-film transistor T1 that is a driving thin-film transistor may be connected to the driving voltage line PL and the storage capacitor Cst, and may control driving current flowing from the driving voltage line PL to an light-emitting diode LED in response to a value of the voltage stored in the storage capacitor Cst. The light-emitting diode LED may emit light having a corresponding luminance due to the driving current. A counter electrode (e.g., a cathode) of the light-emitting diode LED may receive a second power supply voltage ELVSS.

Although the pixel circuit PC includes two thin-film transistors and one storage capacitor in FIG. 5, the disclosure is not limited thereto. The number of thin-film transistors and the number of storage capacitors may be changed in various ways according to a design of the pixel circuit PC. For example, the pixel circuit PC may include three, four, five, or more thin-film transistors.

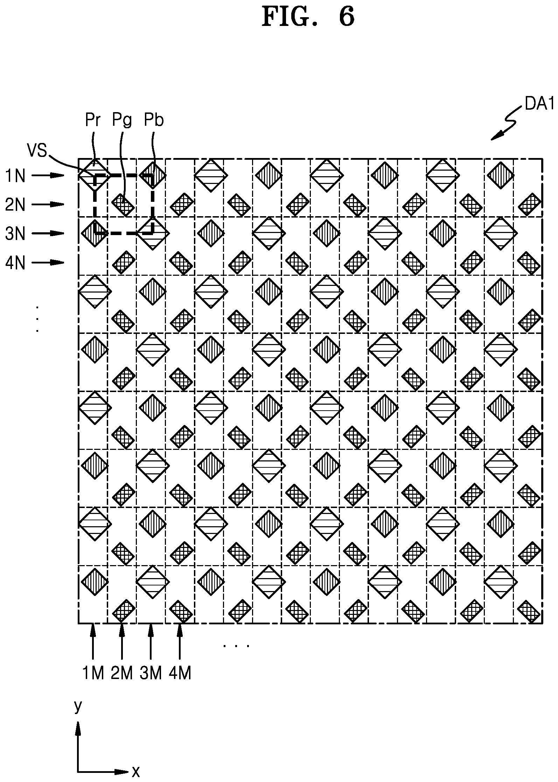

FIG. 6 is a plan view illustrating a part of a first display area of a display apparatus, according to one or more embodiments.

Referring to FIG. 6, pixels may be located in the first display area DA1, and may include first to third pixels for emitting light of different respective colors. For convenience of explanation, the following will be described assuming that the first pixel is a red pixel Pr, the second pixel is a green pixel Pg, and the third pixel is a blue pixel Pb.

The red pixel Pr, the green pixel Pg, and the blue pixel Pb may be arranged in the first display area DA1 according to a corresponding scheme. In some embodiments, the red pixel Pr, the green pixel Pg, and the blue pixel Pb may be arranged in a diamond PenTile^{™} type (e.g., a RGBG matrix structure, a PENTILE^{™} matrix structure, a PENTILE^{™} structure, or an RGBG structure, PENTILE^{™} being a registered trademark of Samsung Display Co., Ltd., Republic of Korea), as shown in FIG. 6.

A plurality of red pixels Pr and a plurality of blue pixels Pb are alternately arranged in a first row 1N, a plurality of green pixels Pg are arranged to be spaced apart from each other by a corresponding interval in a second row 2N adjacent to the first row 1N, a plurality of blue pixels Pb and a plurality of red pixels Pr are alternately arranged in a third row 3N adjacent to the second row 2N, and a plurality of green pixels Pg are arranged to be spaced apart from each other by a corresponding interval in a fourth row 4N adjacent to the third row 3N, and this pixel arrangement is repeated up to an N^{th} row. In this case, a size (or width) of the blue pixel Pb and the red pixel Pr may be greater than a size (or width) of the green pixel Pg.

The plurality of red pixels Pr and blue pixels Pb located in the first row 1N and the plurality of green pixels Pg located in the second row 2N are alternately arranged. Accordingly, a plurality of red pixels Pr and a plurality of blue pixels Pb are alternately arranged in a first column 1M, a plurality of green pixels Pg are arranged to be spaced apart from each other by a corresponding interval in a second column 2M adjacent to the first column 1M, a plurality of blue pixels Pb and a plurality of red pixels Pr are alternately arranged in a third column 3M adjacent to the second column 2M, and a plurality of green pixels Pg are arranged to be spaced apart from each other by a corresponding interval in a fourth column 4M adjacent to the third column 3M, and this pixel arrangement is repeated up to an M^{th} column.

In other words, from among vertices of a virtual quadrangular shape VS having a green pixel Pg as a center point of the virtual quadrangular shape VS, the red pixels Pr may be located at first and third vertices that face each other, and the blue pixels Pb may be located at second and fourth vertices that are the remaining vertices of the virtual quadrangular shape VS. In this case, the virtual quadrangular shape VS may be modified to any of various shapes, such as a rectangular shape, a diamond shape, or a square shape.

Such a pixel arrangement structure may be referred to as a diamond PenTile^{™} type (PENTILE^{™} being a registered trademark of Samsung Display Co., Ltd., Republic of Korea), and a rendering driving method that represents a color by sharing adjacent pixels may be used, thereby displaying an image having a high resolution with a small number of pixels.

The red pixel Pr, the green pixel Pg, and the blue pixel Pb of FIG. 6 may respectively emit red light, green light, and blue light by using light-emitting diodes located in the corresponding pixels. Accordingly, an arrangement of pixels may correspond to an arrangement of light-emitting diodes that are display elements. For example, a position of the red pixel Pr of FIG. 6 may indicate a position of a light-emitting diode that emits red light. Likewise, a position of the green pixel Pg may indicate a position of a light-emitting diode that emits green light, and a position of the blue pixel Pb may indicate a position of a light-emitting diode that emits blue light.

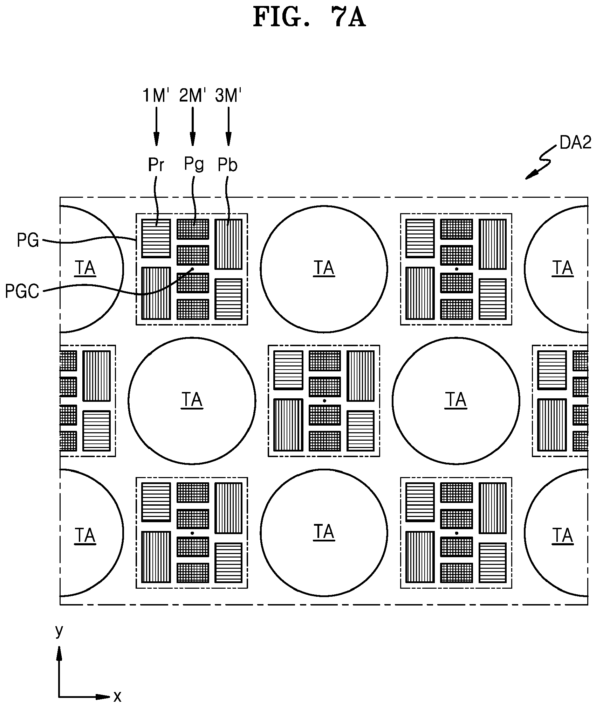

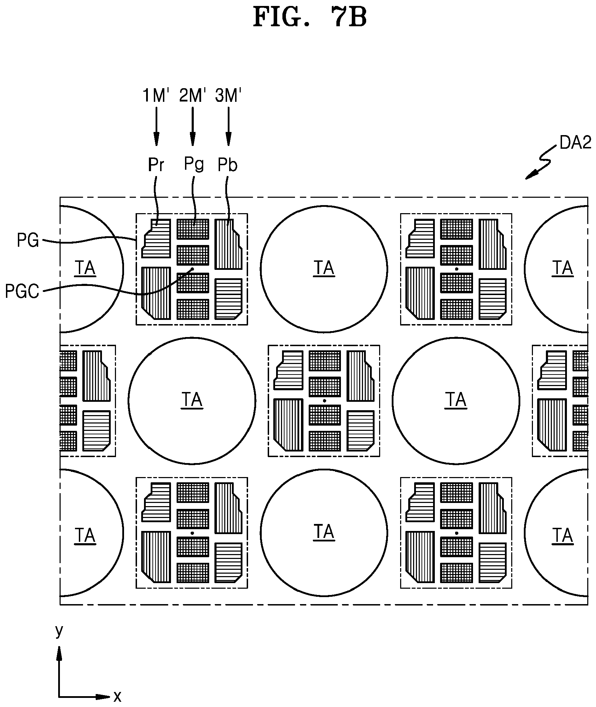

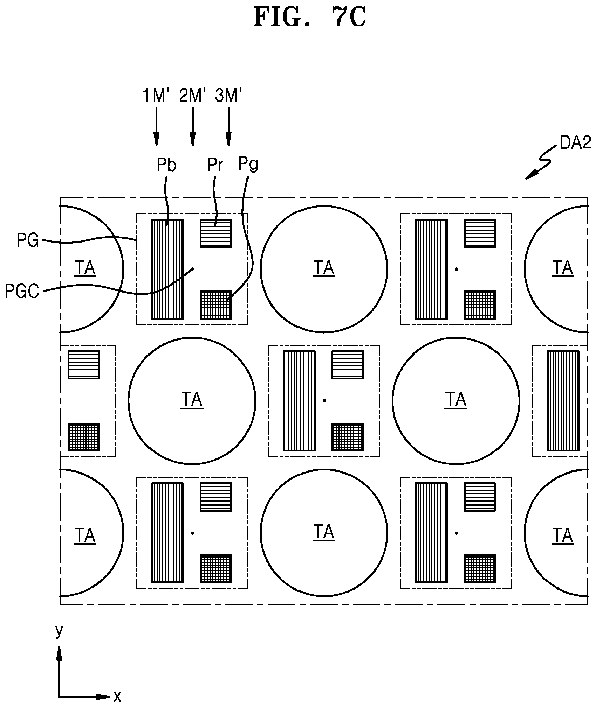

FIGS. 7A and 7B are plan views illustrating a part of a second display area of a display apparatus, according to one or more embodiments. FIG. 7C is a plan view schematically illustrating a pixel group of a second display area of a display apparatus, according to one or more embodiments.

Referring to FIGS. 7A to 7C, pixel groups PG may be located in the second display area DA2 to be spaced apart from each other. Each pixel group PG may be surrounded by the transmission areas TA, and may include pixels for emitting light of different respective colors, for example, the red pixel Pr, the green pixel Pg, and the blue pixel Pb. In one or more embodiments, each pixel group PG may include two red pixels Pr, four green pixels Pg, and two blue pixels Pb. In one or more other embodiments, as shown in FIG. 7C, each pixel group PG may include one red pixel Pr, one green pixel Pg, and one blue pixel Pb.

As described above with reference to FIG. 6, the red pixel Pr, the green pixel Pg, and the blue pixel Pb may respectively emit red light, green light, and blue light by using light-emitting diodes located in corresponding pixels, and thus, an arrangement of pixels may correspond to an arrangement of light-emitting diodes that are display elements. Hence, the pixel group PG described with reference to FIGS. 7A and 7B may correspond to a display element group including a light-emitting diode for emitting red light, a light-emitting diode for emitting green light, and a light-emitting diode for emitting blue light. For example, when the pixel groups PG each including the red pixel Pr, the green pixel Pg, and the blue pixel Pb are spaced apart from each other, it may mean that display element groups each including light-emitting diodes respectively emitting red light, green light, and blue light are spaced apart from each other.

The pixel group PG may be symmetrically located about the center PGC of the pixel group PG. For example, the red pixel Pr and the blue pixel Pb may be located in a first column 1M', and four green pixels Pg may be located in a second column 2M' to be spaced apart from each other by a corresponding interval. Also, the blue pixel Pb and the red pixel Pr may be located in a third column 3M'. In this case, the red pixel Pr located in the first column 1M' and the red pixel Pr located in the third column 3M' may be symmetrically located (e.g., rotationally symmetrical) about the center PGC of the pixel group PG. The blue pixel Pb located in the first column 1M' and the blue pixel Pb located in the third column 3M' may be symmetrically located (e.g., rotationally symmetrical) about the center PGC of the pixel group PG. The green pixels PG located in the second column 2M' may be symmetrically located about the center PGC of the pixel group PG.

In one or more embodiments, a length of the blue pixel Pb in a y-direction may be greater than a length of the red pixel Pr in the y-direction. A length of the blue pixel Pb in the y-direction may be equal to or greater than about a sum of lengths of two green pixels Pg in the y-direction.

Referring to FIG. 7A, each of the red pixel Pr, the green pixel Pg, and the blue pixel Pb may have a substantially quadrangular shape in a plan view. For example, each of the red pixel Pr and the blue pixel Pb may have a quadrangular shape having a short side in an x-direction and a long side in the y-direction. The green pixel Pg may have a quadrangular shape having a long side in the x-direction and a short side in the y-direction.

In one or more other embodiments, at least one of the red pixel Pr, the green pixel Pg, and/or the blue pixel Pb may have an n-gon shape (n corresponds to a natural number equal to or greater than 5). For example, as shown in FIG. 7B, although the green pixel Pg may have a quadrangular shape, the red pixel Pr and the blue pixel Pb may have an n-gon shape (n corresponds to a natural number equal to or greater than 5) because an edge adjacent to a transmission area TA is bent at least once.

A plurality of transmission areas TA may be provided. The transmission areas TA may be located in the second display area DA2 to be spaced apart from each other. In this case, at least one of the plurality of transmission areas TA may have a circular shape in a plan view. In this case, the pixel groups PG may be located on upper, lower, left, and right sides of each transmission area TA. Also, a wiring may be located in a space between the transmission area TA and the pixel group PG.

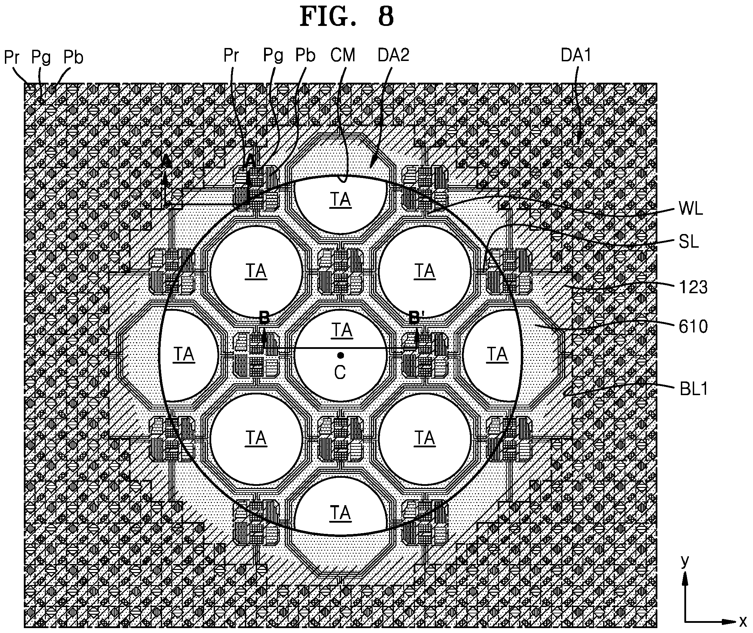

FIG. 8 is a plan view illustrating a second display area and a first display area around the second display area in a display apparatus, according to one or more embodiments.

Referring to FIG. 8, the red, green, and blue pixels Pr, Pg, and Pb are arranged in the first display area DA1 and the second display area DA2. An arrangement of the red, green, and blue pixels Pr, Pg, and Pb located in the first display area DA1 may be the same as, or different from, an arrangement of the red, green, and blue pixels Pr, Pg, and Pb located in the second display area DA2. In one or more embodiments, in FIG. 8, an arrangement of pixels of the first display area DA1 and an arrangement of pixels of the second display area DA2 are different from each other, and a specific structure thereof is the same as that described with reference to FIGS. 6, 7A, and 7B. In one or more other embodiments, the red, green, and blue pixels Pr, Pg, and Pb arranged in each pixel group PG of the second display area DA2 may have a diamond PenTile^{™} structure similar to the red, green, and blue pixels Pr, Pg, and Pb of the first display area DA1 of FIG. 8. In another example, the red, green, and blue pixels Pr, Pg, and Pb arranged in each pixel group PG of the second display area DA2 may have a stripe structure, as shown in FIG. 7C.

A border line BL1 between the first display area DA1 and the second display area DA2 may have a polygonal shape in plan view, as shown in FIG. 8. In one or more embodiments, in FIG. 8, the border line BL1 has a polygonal shape with 12 sides, and a corner portion of the polygonal shape may have a step configuration. In one or more other embodiments, the number of sides of the border line BL1 may be less or greater than 12. For example, the border line BL1 between the first display area DA1 and the second display area DA2 may have a shape with four sides, such as a quadrangular shape, or the border line BL1 may have a polygonal shape with 13 or more sides.

Pixels of the first display area DA1 and pixels of the second display area DA2 may be spaced apart from each other by a corresponding distance, and the distance may be greater than a distance between adjacent pixels located in the first display area DA1, and may be greater than a distance between adjacent pixels located in one pixel group PG in the second display area DA2.

The transmission area TA may be located in the second display area DA2. A plurality of transmission areas TA may be provided, and may be spaced apart from each other. In this case, a planar shape of at least one of the plurality of transmission areas TA may be circular, and a planar shape of each of some of the plurality of transmission areas TA may be a part of a circular shape. For example, in a plan view, the transmission area TA overlapping a boundary of the component 20 may exist only inside the boundary of the component 20, and may not exist outside the boundary of the component 20.

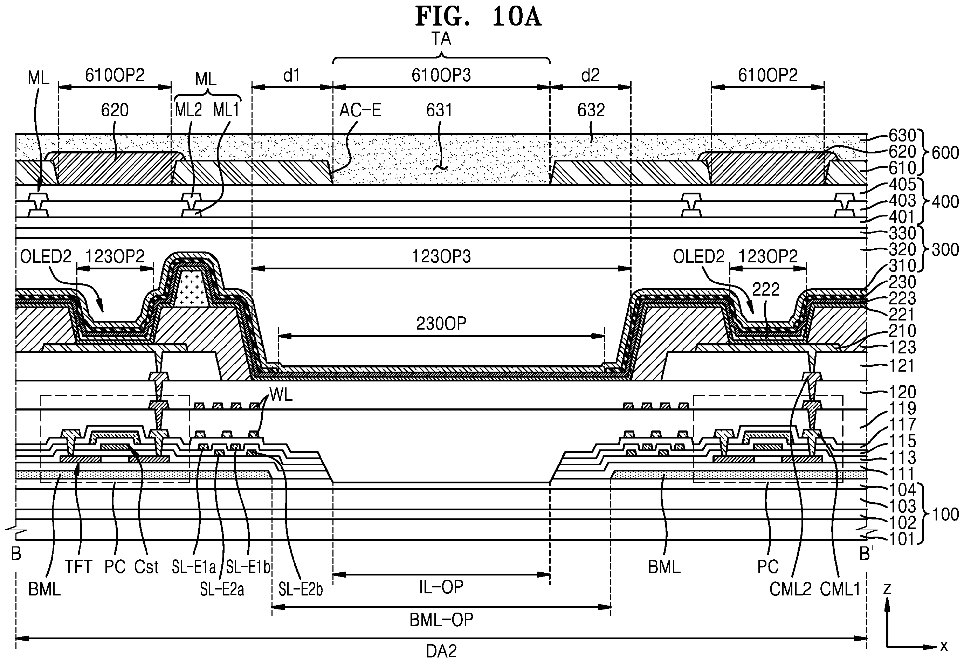

An edge of each transmission area TA may be defined by an edge of a layer including a light-blocking material. The display apparatus may include a light-blocking insulating layer 123 that defines emission areas of light-emitting diodes and the light-blocking layer 610 included in the anti-reflection layer as layers including a light-blocking material, and an edge of the transmission area TA may be defined by an edge of a planar shape of any one of the light-blocking insulating layer 123 and the light-blocking layer 610. In one or more embodiments, in FIG. 8, an edge of the transmission area TA is defined by an edge AC-E (see FIG. 10A) of the light-blocking layer 610.

The transmission area TA is an area through which light and/or sound may be transmitted as described with reference to FIG. 4, and a component CM may overlap a plurality of transmission areas TA as marked in FIG. 8.

In a plan view, an edge of the component 20 (CM) may have a size that is less than a size of the border line BL1 between the first display area DA1 and the second display area DA2.

A planar shape of the transmission area TA located close to the edge of the component 20 (CM) may have a planar shape that is different from that of the transmission area(s) TA located far from the edge of the component 20 (CM) (e.g., toward a center of the area defined by the border line BL1). In one or more embodiments, referring to FIG. 8, the transmission area TA located far from the edge of the component 20 (CM) may have a substantially circular shape, whereas the transmission area TA located close to the edge of the component 20 (CM) may have a shape that is a part of a circular shape.

A horizontal wiring SL and a vertical wiring WL may be located around the transmission area TA. In this case, the horizontal wiring SL and the vertical wiring WL may bypass the transmission area TA. The horizontal wiring SL may refer to a wiring extending in the x-axis direction of FIGS. 1 to 3, and the vertical wiring WL may refer to a wiring extending in the y-axis direction of FIGS. 1 to 3. In this case, at least one of the horizontal wiring SL and/or the vertical wiring WL may include an initialization voltage line, a scan line, a driving voltage line, a data line, an emission control line, and an electrode voltage line. For convenience of explanation, the following will be described assuming that the horizontal wiring SL includes a scan line. At least one of the horizontal wiring SL and/or the vertical wiring WL may be plural. The horizontal wiring SL and the vertical wiring WL may be located on different layers, and thus may be electrically insulated from each other. Also, some of a plurality of horizontal wirings SL may be electrically connected to a pixel circuit of each of the red, green, and blue pixels Pr, Pg, and Pb located in the first display area DA1 and a pixel circuit of each of the red, green, and blue pixels Pr, Pg, and Pb located in the second display area DA2, and others of the plurality of horizontal wirings SL may not be electrically connected to a pixel circuit of each of the red, green, and blue pixels Pr, Pg, and Pb located in the second display area DA2, but instead may be electrically connected to a pixel circuit of the red, green, and blue pixels Pr, Pg, and Pb located in the first display area DA1.

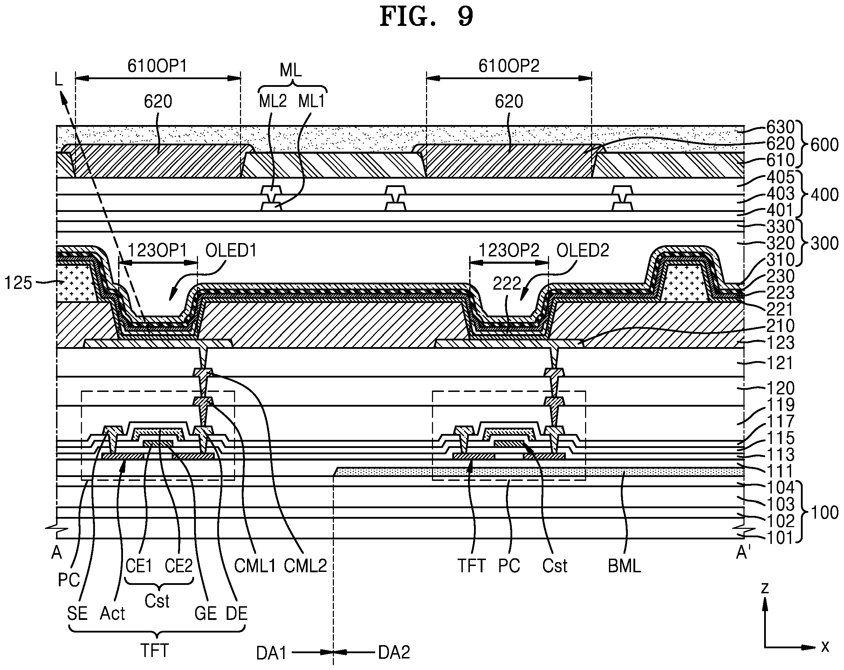

FIG. 9 is a cross-sectional view taken along the line A-A' of FIG. 8. FIG. 9 illustrates a case where a light-emitting diode of a display apparatus includes an organic light-emitting diode. An organic light-emitting diode may be located as a light-emitting diode in each of the first and second display areas DA1 and DA2, and for convenience of explanation, an organic light-emitting diode located in the first display area DA1 is referred to as a first organic light-emitting diode OLED1, while an organic light-emitting diode located in the second display area DA2 is referred to as a second organic light-emitting diode OLED2.

Referring to FIG. 9, the first organic light-emitting diode OLED1 and the second organic light-emitting diode OLED2 are formed on the substrate 100.

The substrate 100 may include a first base layer 101, a first barrier layer 102, a second base layer 103, and a second barrier layer 104. The first base layer 101 and the second base layer 103 may include a polymer resin, and the first barrier layer 102 and the second barrier layer 104 may each include an inorganic insulating material. The polymer resin may include polyethersulfone, polyacrylate, polyether imide, polyethylene naphthalate, polyethylene terephthalate, polyphenylene sulfide, polyarylate, polyimide, polycarbonate, and/or cellulose acetate propionate.

The buffer layer 111 is located on (e.g., above) the substrate 100. The buffer layer 111 may reduce or prevent penetration of a foreign material, moisture, or external air from the bottom of the substrate 100. The buffer layer 111 may include an inorganic insulating material, such as silicon oxide, silicon oxynitride, or silicon nitride, and may have a single-layer or multi-layer structure including the above material.

The blocking metal layer BML may be located between the substrate 100 and the buffer layer 111, and may be located in the second display area DA2. The blocking metal layer BML may reduce or prevent light traveling toward the component CM (see FIG. 8) located in the second display area DA2, or light emitted from the component CM (see FIG. 8), from affecting an electronic element, such as the thin-film transistor TFT of the pixel circuit PC. The blocking metal layer BML may include a conductive metal, such as aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu).

Each of the first organic light-emitting diode OLED1 and the second organic light-emitting diode OLED2 may be electrically connected to the pixel circuit PC. The first organic light-emitting diode OLED1 may be electrically connected to the pixel circuit PC that is between the substrate 100 and the first organic light-emitting diode OLED1. The second organic light-emitting diode OLED2 may be electrically connected to the pixel circuit PC that is between the substrate 100 and the second organic light-emitting diode OLED2.

The pixel circuit PC may include a thin-film transistor TFT and a storage capacitor Cst. The thin-film transistor TFT may include a semiconductor layer Act, a gate electrode GE overlapping a channel region of the semiconductor layer Act, and a source electrode SE and a drain electrode DE respectively connected to a source region and a drain region of the semiconductor layer Act. A gate insulating layer 113 may be located between the semiconductor layer Act and the gate electrode GE, and a first interlayer insulating layer 115 and a second interlayer insulating layer 117 may be located between the gate electrode GE and the source electrode SE, or between the gate electrode GE and the drain electrode DE.

The storage capacitor Cst may overlap the thin-film transistor TFT. The storage capacitor Cst may include a lower electrode CE1 and an upper electrode CE2 overlapping each other. In some embodiments, the gate electrode GE of the thin-film transistor TFT may include the lower electrode CE1 of the storage capacitor Cst. The first interlayer insulating layer 115 may be located between the lower electrode CE1 and the upper electrode CE2.

The semiconductor layer Act may include polysilicon. In some embodiments, the semiconductor layer Act may include amorphous silicon. In some embodiments, the semiconductor layer Act may include an oxide semiconductor of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), and/or zinc (Zn). The semiconductor layer Act may include the channel region, and may also include the source region and the drain region doped with impurities.

The gate insulating layer 113 may include an inorganic insulating material, such as silicon oxide, silicon oxynitride, and/or silicon nitride, and may have a single-layer or multi-layer structure including the above material.

The gate electrode GE or the lower electrode CE1 may include a low-resistance conductive material, such as molybdenum (Mo), aluminium (Al), copper (Cu), and/or titanium (Ti), and may have a single-layer or multi-layer structure including the above material.

The first interlayer insulating layer 115 may include an inorganic insulating material, such as silicon oxide, silicon oxynitride, and/or silicon nitride, and may have a single-layer or multi-layer structure including the above material.

The upper electrode CE2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer or multi-layer structure including the above material.

The second interlayer insulating layer 117 may include an inorganic insulating material, such as silicon oxide, silicon oxynitride, and/or silicon nitride, and may have a single-layer or multi-layer structure including the above material.

The source electrode SE and/or the drain electrode DE may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer or multi-layer structure including the above material. For example, the source electrode SE and/or the drain electrode DE may have a three-layer structure including a titanium layer, an aluminium layer, and a titanium layer.

A first organic insulating layer 119, a second organic insulating layer 120, and a third organic insulating layer 121 may be sequentially located on the thin-film transistor TFT, and the thin-film transistor TFT may be connected to a second connection electrode layer CML2 located on the second organic insulating layer 120 through a first connection electrode layer CML1 located on the first organic insulating layer 119. In this case, the first connection electrode layer CML1 may be connected to the thin-film transistor TFT through a contact hole formed in the first organic insulating layer 119. The second connection electrode layer CML2 may be electrically connected to a first electrode 210 of an organic light-emitting diode corresponding to the thin-film transistor TFT. In this case, the first electrode 210 may be connected to the second connection electrode layer CML2 through a contact hole formed in the third organic insulating layer 121.

The first organic insulating layer 119, the second organic insulating layer 120, and/or the third organic insulating layer 121 may include an organic insulating material, such as acryl, benzocyclobutene (BCB), polyimide, or hexamethyldisiloxane (HMDSO). In some embodiments, the second connection electrode layer CML2 and the second organic insulating layer 120 may be omitted, and in this case, the first electrode 210 may be connected to the thin-film transistor TFT through the first connection electrode layer CML1. In one or more other embodiments, the first connection electrode layer CML1, the second connection electrode layer CML2, the second organic insulating layer 120, and the third organic insulating layer 121 may be omitted, and in this case, the first electrode 210 may be directly connected to the thin-film transistor TFT through a contact hole formed in the first organic insulating layer 119.

Each of the first organic light-emitting diode OLED1 and the second organic light-emitting diode OLED2 may include an overlapping structure of the first electrode 210, an emission layer 222, and a second electrode 230. The overlapping structure may include a first functional layer 221 between the first electrode 210 and the emission layer 222, and/or a second functional layer 223 between the emission layer 222 and the second electrode 230.

The first electrode 210 may be located on the third organic insulating layer 121. The first electrode 210 may include a reflective film including silver (Ag), magnesium (Mg), aluminium (Al), platinum (Pt), palladium (Pd), gold (Au), nickel (Ni), neodymium (Nd), iridium (Ir), chromium (Cr), and/or a compound thereof. The first electrode 210 may include the reflective film including the above material, and a transparent conductive film located over and/or under the reflective film. The transparent conductive film may include indium tin oxide (ITO), indium zinc oxide (IZO), zinc oxide (ZnO), indium oxide (In₂O₃), indium gallium oxide (IGO), and/or aluminium zinc oxide (AZO). In one or more embodiments, the first electrode 210 may have a three-layer structure including an ITO layer, an Ag layer, and an ITO layer.

The light-blocking insulating layer 123 may cover an edge of the first electrode 210, and may include/define an opening overlapping the first electrode 210. In this regard, FIG. 9 illustrates an opening (hereinafter, referred to as a first opening 123OP1) overlapping the first electrode 210 of the first organic light-emitting diode OLED1, and an opening (hereinafter, referred to as a second opening 123OP2) overlapping the first electrode 210 of the second organic light-emitting diode OLED2.

The first opening 123OP1 and the second opening 123OP2 of the light-blocking insulating layer 123 may respectively define emission areas of the first and second organic light-emitting diodes OLED1 and OLED2. For example, a width of the first opening 123OP1 of the light-blocking insulating layer 123 may correspond to a width of the emission area of the first organic light-emitting diode OLED1, and a width of the second opening 123OP2 of the light-blocking insulating layer 123 may correspond to a width of the emission area of the second organic light-emitting diode OLED2.

The light-blocking insulating layer 123 that is a colored insulating layer may be, for example, black. For example, the light-blocking insulating layer 123 may include a polyimide (PI)-based binder, and a pigment in which red, green, and blue colors are mixed. Alternatively, the light-blocking insulating layer 123 may include a cardo-based binder resin, and a mixture of a lactam black pigment and a blue pigment. Alternatively, the light-blocking insulating layer 123 may include carbon black. The light-blocking insulating layer 123 may reduce or prevent reflection of external light together with the anti-reflection layer 600 described below, and may improve a contrast of the display apparatus.

A spacer 125 may be located on the light-blocking insulating layer 123. The spacer 125 may include a material that is different from that of the light-blocking insulating layer 123. For example, the light-blocking insulating layer 123 may include a negative photosensitive material, and the spacer 125 may include a positive photosensitive material. The light-blocking insulating layer 123 and the spacer 125 may be formed by using separate mask processes.

The emission layer 222 may correspond to each of the first opening 123OP1 and the second opening 123OP2 of the light-blocking insulating layer 123, and may overlap the first electrode 210. The emission layer 222 may include a high molecular weight organic material or a low molecular weight organic material for emitting light of a corresponding color. The first functional layer 221 and the second functional layer 223 may be formed under and over the emission layer 222 respectively.

The first functional layer 221 may include a hole transport layer (HTL), and/or a hole injection layer (HIL). The second functional layer 223 may include an electron transport layer (ETL) and/or an electron injection layer (EIL). The first functional layer 221 and/or the second functional layer 223 may be formed on the entire substrate 100 (e.g., over an entirety of the substrate 100), unlike the emission layer 222. In other words, the first functional layer 221 and/or the second functional layer 223 may cover the first display area DA1 and the second display area DA2.

The encapsulation layer 300 may cover the first and second organic light-emitting diodes OLED1 and OLED2. In one or more embodiments, the encapsulation layer 300 may include the first inorganic encapsulation layer 310, the second inorganic encapsulation layer 330, and the organic encapsulation layer 320 between the first inorganic encapsulation layer 310 and the second inorganic encapsulation layer 330.

Each of the first and second inorganic encapsulation layers 310 and 330 may include at least one inorganic insulating material. The inorganic insulating material may include aluminium oxide, titanium oxide, tantalum oxide, hafnium oxide, zinc oxide, silicon oxide, silicon nitride, and/or silicon oxynitride.

The organic encapsulation layer 320 may include a polymer-based material. Examples of the polymer-based material may include an acrylic resin, an epoxy resin, polyimide, and polyethylene. For example, the organic encapsulation layer 320 may include an acrylic resin, such as polymethyl methacrylate and/or polyacrylic acid. The organic encapsulation layer 320 may be formed by curing a monomer or by applying a polymer.

The input sensing layer 400 may include a touch electrode, and the touch electrode may include a metal line ML. The touch electrode may include the metal line ML having a mesh structure surrounding the emission areas of the first and second light emitting didoes OLED1 and OLED2. The metal line ML may have a connection structure of a first metal layer ML1 and a second metal layer ML2, as shown in FIG. 9. In one or more other embodiments, the metal line ML may include any one of the first metal layer ML1 and the second metal layer ML2. The metal line ML may include molybdenum (Mo), silver (Ag), titanium (Ti), copper (Cu), aluminium (Al), and an alloy thereof. An electrode, for example, the metal line ML, of the input sensing layer 400 may be covered by the light-blocking layer 610.

The input sensing layer 400 may include a first touch insulating layer 401 on the encapsulation layer 300, a second touch insulating layer 403 on the first touch insulating layer 401, and a third touch insulating layer 405 on the second touch insulating layer 403. The first metal layer ML1 may be located between the first touch insulating layer 401 and the second touch insulating layer 403, and the second metal layer ML2 may be located between the second touch insulating layer 403 and the third touch insulating layer 405.

Each of the first to third touch insulating layers 401, 403, and 405 may include an inorganic insulating material and/or an organic insulating material. In one or more embodiments, each of the first touch insulating layer 401 and the second touch insulating layer 403 may include an inorganic insulating material, and the third touch insulating layer 405 may include an organic insulating material.

The light-blocking layer 610 of the anti-reflection layer 600 may include/define an opening overlapping the emission areas of the first and second organic light-emitting diodes OLED1 and OLED2. In this regard, FIG. 9 illustrates an opening (hereinafter, referred to as a fourth opening 610OP1) overlapping the emission area of the first organic light-emitting diode OLED1 and/or the first opening 123OP1 of the light-blocking insulating layer 123. FIG. 9 also illustrates an opening (hereinafter, referred to as a fifth opening 610OP2) overlapping the emission area of the second organic light-emitting diode OLED2 and/or the second opening 123OP2 of the light-blocking insulating layer 123.

A width of the fourth opening 610OP1 of the light-blocking layer 610 may be equal to or greater than a width of the emission area of the first organic light-emitting diode OLED1 and/or equal to or greater than a width of the first opening 123OP1 of the light-blocking insulating layer 123. In this regard, in FIG. 9, a width of the fourth opening 610OP1 of the light-blocking layer 610 is greater than a width of the emission area of the first organic light-emitting diode OLED1 and/or the first opening 123OP1 of the light-blocking insulating layer 123. In this case, light L reaching a user's eyes, and forming an acute angle with a top surface of the anti-reflection layer 600, may be sufficiently ensured, and thus, side visibility of the display apparatus may be improved.

Likewise, a width of the fifth opening 610OP2 of the light-blocking layer 610 may be equal to or greater than a width of the emission area of the second organic light-emitting diode OLED2 and/or equal to or greater than a width of the second opening 123OP2 of the light-blocking insulating layer 123. In this regard, in FIG. 9, a width of the fifth opening 610OP2 of the light-blocking layer 610 is greater than a width of the emission area of the second organic light-emitting diode OLED2 and/or the second opening 123OP2 of the light-blocking insulating layer 123.

The color filter 620 may be located in each of the fourth opening 610OP1 and the fifth opening 610OP2 of the light-blocking layer 610. Each color filter 620 may have the same color as a color of light emitted from a light-emitting diode located thereunder. For example, as shown in FIG. 9, when the first organic light-emitting diode OLED1 of the first display area DA1 emits green light, the color filter 620 located in the fourth opening 610OP1 to overlap the first organic light-emitting diode OLED1 may include a green color filter. Likewise, as shown in FIG. 9, when the second organic light-emitting diode OLED2 of the second display area DA2 emits blue light, the color filter 620 located in the fifth opening 610OP2 to overlap the second organic light-emitting diode OLED2 may include a blue color filter.

The overcoat layer 630 may be located on the light-blocking layer 610 and the color filter 620. The overcoat layer 630 that is a light-transmitting layer not having a color in a visible band may planarize a top surface of the light-blocking layer 610 and a top surface of the color filter 620. The overcoat layer 630 may include a light-transmitting organic material, such as an acrylic resin.

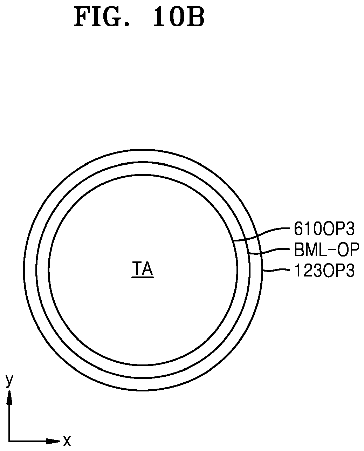

FIG. 10A is a cross-sectional view taken along the line B-B' of FIG. 8. FIG. 10B is a plan view schematically illustrating positions of openings of FIG. 10A. FIG. 10A illustrates a cross-sectional structure of a transmission area located at a center position from among a plurality of transmission areas of FIG. 8 and its surroundings.

Referring to FIGS. 10A and 10B, the transmission area TA may be located between two adjacent second organic light-emitting diodes OLED2 from among a plurality of second organic light-emitting diodes OLED2 located in the second display area DA2. Each second organic light-emitting diode OLED2 may be electrically connected to the pixel circuit PC. The pixel circuit PC on the substrate 100 may include the thin-film transistor TFT and the storage capacitor Cst, and the second organic light-emitting diode OLED2 may have an overlapping structure of the first electrode 210, the emission layer 222, and the second electrode 230, and may be covered by the encapsulation layer 300. The input sensing layer 400 and the anti-reflection layer 600 may be located on the encapsulation layer 300 as described above.

The light-blocking insulating layer 123 may include/define an opening (hereinafter, referred to as a third opening 123OP3) corresponding to the transmission area TA, and the light-blocking layer 610 may include/define an opening (hereinafter, referred to as a sixth opening 610OP3) corresponding to the transmission area TA. A part of the overcoat layer 630 may be located in the sixth opening 610OP3. For example, a first portion 631 of the overcoat layer 630 may at least partially fill the sixth opening 610OP3, and a second portion 632 integrally formed with the first portion 631 may entirely cover the light-blocking layer 610 and the color filters 620.

The sixth opening 610OP3 may overlap the third opening 123OP3, and a size (or width) of the sixth opening 610OP3 may be less than a size (or width) of the third opening 123OP3. In other words, a part of the third opening 123OP3 may be covered by a portion of the light-blocking layer 610 located on a side of the edge AC-E of the light-blocking layer 610.

Referring to FIGS. 8 and 10A, the transmission area TA may be defined by the sixth opening 610OP3 of the light-blocking layer 610. In this case, the transmission area TA may have a circular planar shape as shown in FIG. 10B. In the transmission area TA located in a planar shape of the component from among the plurality of transmission areas TA, edges of the light-blocking layer 610 located on both sides of the sixth opening 610OP3 of FIG. 10A may be spaced apart from edges of the light-blocking insulating layer 123 located on both sides of the third opening 123OP3, and separation distances thereof may be the same. For example, an edge of the light-blocking layer 610 located on a left side of the sixth opening 610OP3 of FIG. 10A, for example, the edge AC-E, may be spaced apart from an edge of the light-blocking insulating layer 123 located on a left side of the third opening 123OP3 by a first distance d1 (e.g., in plan view). An edge of the light-blocking layer 610 located on a right side of the sixth opening 610OP3 may be spaced apart from an edge of the light-blocking insulating layer 123 located on a right side of the third opening 123OP3 by a second distance d2 (e.g., in plan view). In this case, the first distance d1 may be the same as the second distance d2. In contrast, in the transmission area TA located on an edge of the planar shape of the component from among the plurality of transmission areas TA, edges of the light-blocking layer 610 located on both sides of the sixth opening 610OP3 of FIG. 10A may be spaced apart from edges of the light-blocking insulating layer 123 located on both sides of the third opening 123OP3, and separation distances thereof may be different from each other. In this case, one of the first distance d1 and the second distance d2 may be greater than the other, and a part of the third opening 123OP3 may overlap the sixth opening 610OP3, while the rest of the third opening 123OP3 may be covered by the light-blocking layer 610.

The first and second functional layers 221 and 223 may also be located in a portion corresponding to the transmission area TA. In contrast, the second electrode 230 including a metal element may include/define an opening (hereinafter, referred to as a seventh opening 230OP) corresponding to the transmission area TA. A transmittance of the transmission area TA may be improved by the seventh opening 230OP. A size (or width) of the seventh opening 230OP of the second electrode 230 may be less than a size (or width) of the third opening 123OP3.

Some insulating layers (e.g., inorganic insulating layers) from among insulating layers located under the first electrode 210 may also include/define an opening corresponding to the transmission area TA. For example, a stack of the second barrier layer 104, the buffer layer 111, the gate insulating layer 113, the first interlayer insulating layer 115, and the second interlayer insulating layer 117 may include an inorganic insulating material, and the stack may include/define an opening (hereinafter, referred to as an eighth opening IL-OP) corresponding to the transmission area TA. A part of the first organic insulating layer 119 located on the stack may be located in the eighth opening IL-OP. In FIG. 10A, the eighth opening IL-OP includes an overlapping structure of through-holes passing through the buffer layer 111, the gate insulating layer 113, the first interlayer insulating layer 115, and the second interlayer insulating layer 117, and a blind hole (e.g., indentation) of the second barrier layer 104. In one or more other embodiments, the eighth opening IL-OP may not include the blind hole of the second barrier layer 104.

The blocking metal layer BML located between the substrate 100 and the pixel circuit PC may include/define an opening (hereinafter, referred to as a ninth opening BML-OP) overlapping the transmission area TA, and a size (or width) of the ninth opening BML-OP may be greater than a size (or width) of the eighth opening IL-OP of the stack of the insulating layers. A size (or width) of the ninth opening BML-OP may be less than a size (or width) of the third opening 123OP3.

In this case, the transmission area TA may be defined by the third opening 123OP3 and the sixth opening 610OP3. In this case, each of the third opening 123OP3, the sixth opening 610OP3, and the ninth opening BML-OP may have a circular planar shape. In this case, in a plan view, the sixth opening 610OP3 may be located inside the ninth opening BML-OP, and the ninth opening BML-OP may be located inside the third opening 123OP3. Also, in a plan view, the third opening 123OP3 may have the same circumference as the sixth opening 610OP3, or any one of the third opening 123OP3 and the sixth opening 610OP3 may be located inside the other of the third opening 123OP3 and the sixth opening 610OP3. For convenience of explanation, the following will be described assuming that, in a plan view, the ninth opening BML-OP is located inside the third opening 123OP3, and the sixth opening 610OP3 is located inside the ninth opening BML-OP.

The transmission area TA may be defined by the ninth opening BML-OP. In this case, because the transmission area TA is formed in a circular shape, refraction of light (or external signal) incident on the component CM (see FIG. 8) may be reduced. Accordingly, the component CM (see FIG. 8) may accurately receive a signal, such as an external image while reducing distortion of external light (or external signal).

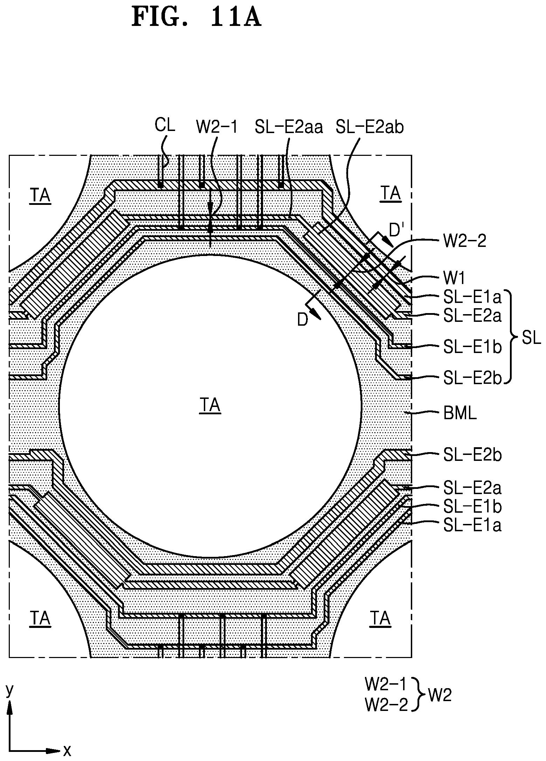

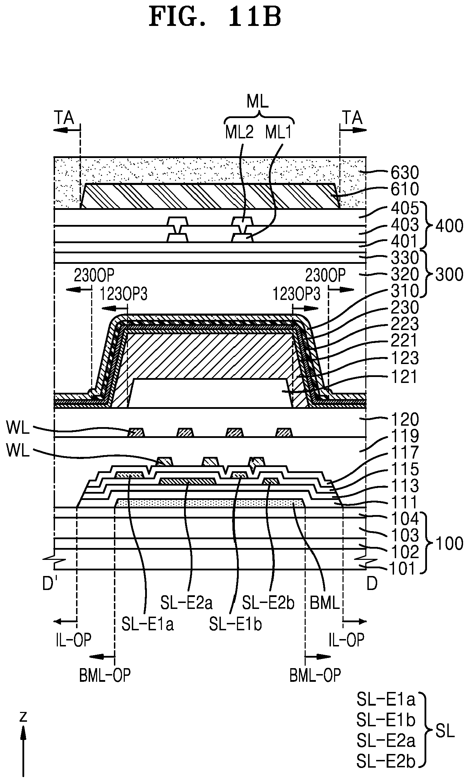

FIG. 11A is a plan view schematically illustrating a horizontal wiring and a transmission area of FIG. 8. FIG. 11B is a cross-sectional view taken along the line D-D' of FIG. 11A. FIG. 11B is a cross-sectional view schematically illustrating a part of a second display area of FIG. 11A.

Referring to FIGS. 11A and 11B, the horizontal wiring SL may be selectively connected to a pixel circuit of a pixel of each display area. The horizontal wiring SL may include a first horizontal wiring configured to transmit a signal to a pixel circuit of a pixel of a first display area and to a pixel circuit of a pixel of a second display area. In this case, a plurality of first horizontal wirings may be provided. For example, the first horizontal wiring may include a 1-1^{th} horizontal wiring SL-E1a and a 1-2^{th} horizontal wiring SL-E1b. The horizontal wiring SL may include a bridge wiring CL configured to connect one of the 1-1^{th} horizontal wiring SL-E1a or the 1-2^{th} horizontal wiring SL-E1b to a pixel circuit of a pixel of the second display area. The horizontal wiring SL may include a second horizontal wiring connected to a pixel circuit of a pixel of the first display area and not connected to a pixel circuit of a pixel of the second display area. In this case, the second horizontal wiring may include a 2-1^{th} horizontal wiring SL-E2a and a 2-2^{th} horizontal wiring SL-E2b.

The 1-1^{th} horizontal wiring SL-E1a, the 1-2^{th} horizontal wiring SL-E1b, the 2-1^{th} horizontal wiring SL-E2a, and the 2-2^{th} horizontal wiring SL-E2b may bypass the transmission area TA. In this case, a direction in which at least one of the 1-1^{th} horizontal wiring SL-E1a, the 1-2^{th} horizontal wiring SL-E1b, the 2-1^{th} horizontal wiring SL-E2a, and/or the 2-2^{th} horizontal wiring SL-E2b is located may be variable. For example, at least one of the 1-1^{th} horizontal wiring SL-E1a, the 1-2^{th} horizontal wiring SL-E1b, the 2-1^{th} horizontal wiring SL-E2a, and/or the 2-2^{th} horizontal wiring SL-E2b may include one portion extending in a first direction (e.g., the x-axis direction of FIG. 11A), and may include another portion extending diagonally with respect to the first direction. In this case, because the 1-1^{th} horizontal wiring SL-E1a and the 1-2^{th} horizontal wiring SL-E1b may be similar to each other, and the 2-1^{th} horizontal wiring SL-E2a and the 2-2^{th} horizontal wiring SL-E2b are similar to each other, the 1-1^{th} horizontal wiring SL-E1a and the 2-1^{th} horizontal wiring SL-E2a will be mainly described in detail.

In a plan view, a first width W1 of the 1-1^{th} horizontal wiring SL-E1a may be almost constant over the entire 1-1^{th} horizontal wiring SL-E1a. In a plan view, a second width W2 of the 2-1^{th} horizontal wiring SL-E2a may vary according to each portion of the 2-1^{th} horizontal wiring SL-E2a. For example, the 2-1^{th} horizontal wiring SL-E2a may include a first wiring portion SL-E2aa extending in the first direction, and a second wiring portion SL-E2ab extending diagonally with respect to the first direction. In this case, a 2-1^{th} width W2-1 of the first wiring portion SL-E2aa may be different from a 2-2^{th} width W2-2 of the second wiring portion SL-E2ab. In detail, the 2-1^{th} width W2-1 may be less than the 2-2^{th} width W2-2. In this case, in one or more embodiments, the second width W2 of the 2-1^{th} horizontal wiring SL-E2a located in the first display area may be the same as the 2-1^{th} width W2-1. In one or more embodiments, the 2-1^{th} horizontal wiring SL-E2a may be formed so that the 2-1^{th} width W2-1 is greater than the 2-2^{th} width W2-2. A width used herein may refer to a shortest distance between two facing side surfaces of each wiring.

When the 1-1^{th} horizontal wiring SL-E1a and the 2-1^{th} horizontal wiring SL-E2a have the same width, the 1-1^{th} horizontal wiring SL-E1a and the 2-1^{th} horizontal wiring SL-E2a may have different resistances. In detail, because the 1-1^{th} horizontal wiring SL-E1a is connected to the bridge wiring CL in the second display area, a resistance of one 1-1^{th} horizontal wiring SL-E1a and a resistance of the 2-1^{th} horizontal wiring SL-E2a, crossing the display apparatus in the first direction, may be different from each other. In this case, respective brightnesses of a pixel of the first display area connected to the 1-1^{th} horizontal wiring SL-E1a and a pixel of the first display area connected to the 2-1^{th} horizontal wiring SL-E2a may be different.

However, because a width of a part of the 2-1^{th} horizontal wiring SL-E2a is greater than a width of another portion as described above, a total resistance of the 1-1^{th} horizontal wiring SL-E1a and a total resistance of the 2-1^{th} horizontal wiring SL-E2a, crossing the display apparatus in the first direction, may be the same or similar to each other, thereby reducing or preventing the likelihood of the above problem.

Accordingly, the display apparatus may reduce a resistance deviation between the horizontal wirings SL.

In addition, when a resistance difference occurs between the 1-1^{th} horizontal wiring SL-E1a and the 2-1^{th} horizontal wiring SL-E2a, light of different luminances may be generated due to heating or the like when a signal is applied to the 1-1^{th} horizontal wiring SL-E1a and the 2-1^{th} horizontal wiring SL-E2a, and thus, the likelihood of one of the 1-1^{th} horizontal wiring SL-E1a or the 2-1^{th} horizontal wiring SL-E2a being seen may be reduced or prevented.

Although a width of the 2-2^{th} horizontal wiring SL-E2b is the same (e.g., constant), the disclosure is not limited thereto, and the 2-2^{th} horizontal wiring SL-E2b may also be formed so that a width is variable, like the 2-1^{th} horizontal wiring SL-E2a. Also, in the 2-1^{th} horizontal wiring SL-E2a and the 2-2^{th} horizontal wiring SL-E2b, a width of only a part of a portion crossing the entire display apparatus may be different as shown in FIG. 11A.

The 1-1^{th} horizontal wiring SL-E1a and the 1-2^{th} horizontal wiring SL-E1b may be located on the same layer, and the 2-1^{th} horizontal wiring SL-E2a and the 2-2^{th} horizontal wiring SL-E2b may be located on the same layer. In this case, the 1-1^{th} horizontal wiring SL-E1a and the 1-2^{th} horizontal wiring SL-E1b may be respectively located on the same layer as, or a different layer from, the 2-1^{th} horizontal wiring SL-E2a and the 2-2^{th} horizontal wiring SL-E2b. For example, in one or more embodiments, the 2-1^{th} horizontal wiring SL-E2a and the 2-2^{th} horizontal wiring SL-E2b may be located on the gate insulating layer 113, and the 1-1^{th} horizontal wiring SL-E1a and the 1-2^{th} horizontal wiring SL-E1b may be located on the first interlayer insulating layer 115. Also, the vertical wiring WL may be located on at least one of the second interlayer insulating layer 117, the first organic insulating layer 119, the second organic insulating layer 120, and/or the third organic insulating layer 121.

In one or more other embodiments, the 1-1^{th} horizontal wiring SL-E1a and the 1-2^{th} horizontal wiring SL-E1b may be located on the gate insulating layer 113, and the 2-1^{th} horizontal wiring SL-E2a and the 2-2^{th} horizontal wiring SL-E2b may be located on the first interlayer insulating layer 115. In this case, the vertical wiring WL may be located on at least one of the second interlayer insulating layer 117, the first organic insulating layer 119, the second organic insulating layer 120, and/or the third organic insulating layer 121. In one or more other embodiments, the 1-1^{th} horizontal wiring SL-E1a, the 1-2^{th} horizontal wiring SL-E1b, the 2-1^{th} horizontal wiring SL-E2a, and the 2-2^{th} horizontal wiring SL-E2b may be located on the gate insulating layer 113 or the first interlayer insulating layer 115.

In one or more other embodiments, the horizontal wiring SL is not limited thereto, and may be located on a layer on which the vertical wiring WL of FIG. 11B is located. In this case, the horizontal wiring SL of FIG. 11A may be located on a layer located on the vertical wiring WL.

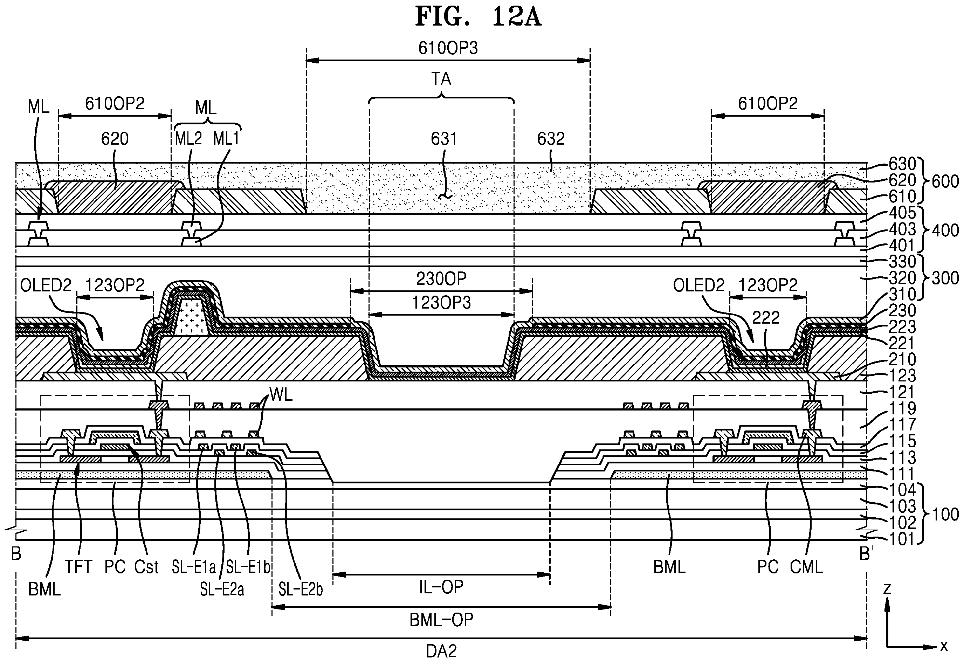

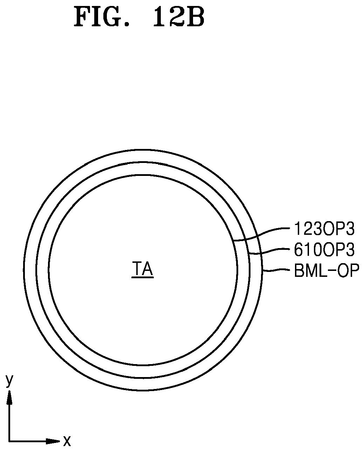

FIG. 12A is a cross-sectional view schematically illustrating a part of a display apparatus, according to one or more other embodiments. FIG. 12B is a plan view schematically illustrating positions of openings of FIG. 12A. FIG. 12A illustrates a cross-sectional structure illustrating a transmission area from among a plurality of transmission areas and its surroundings. Structures other than a structure of the light-blocking insulating layer 123 and the light-blocking layer 610 of FIG. 12A are the same as those described with reference to FIG. 9, and thus, a difference will be mainly described.

Referring to FIGS. 12A and 12B, a size (or width) of the transmission area TA may be defined by the light-blocking insulating layer 123. The light-blocking insulating layer 123 may include the third opening 123OP3 corresponding to the transmission area TA, and the light-blocking layer 610 may also include the sixth opening 610OP3 corresponding to the transmission area TA. The sixth opening 610OP3 may overlap the third opening 123OP3, and a size (or width) of the sixth opening 610OP3 may be greater than a size (or width) of the third opening 123OP3.

A stack of the second electrode 230, the blocking metal layer BML, and inorganic insulating layers may include/define an opening overlapping the transmission area TA. A size (or width) of the seventh opening 230OP of the second electrode 230 may be greater than a size (or width) of the third opening 123OP3.

A size (or width) of the ninth opening BML-OP of the blocking metal layer BML may be greater than a size (or width) of the eighth opening IL-OP of the stack of the insulating layers. A size (or width) of the ninth opening BML-OP may be greater than a size (or width) of the third opening 123OP3.

Referring to FIG. 12B, in a plan view, the third opening 123OP3 may have a circular shape, and may define the transmission area TA. The third opening 123OP3 may be located inside the ninth opening BML-OP. Also, the sixth opening 610OP3 may be located inside (e.g., in plan view) the ninth opening BML-OP.

Accordingly, the display apparatus may reduce diffraction of light (or an external signal) introduced into the component, and may generate the same diffraction at an edge of the transmission area TA to obtain a clear image or receive an external signal.

The display apparatus according to embodiments may reduce diffraction of an external signal when receiving the external signal. The display apparatus according to the embodiments may keep uniform resistance values of a wiring connected to a pixel of the second display area and a wiring passing through the second display area.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope as defined by the following claims, with functional equivalents thereof to be included therein.

## Claims

1. A display apparatus comprising:
a first display area in which first light-emitting diodes are arranged;
a second display area at least partially surrounded by the first display area in plan view, and in which display element groups comprising second light-emitting diodes and transmission areas are arranged, at least one of the transmission areas having a circular shape;
a light-blocking insulating layer defining emission areas of the first light-emitting diodes and the second light-emitting diodes; and
an anti-reflection layer above the light-blocking insulating layer, and comprising a light-blocking layer and color filters,
wherein one or more of the transmission areas are defined in plan view by a circular opening defined by at least one of the light-blocking layer or the light-blocking insulating layer.

2. The display apparatus of claim 1, further comprising a blocking metal layer in the second display area.

3. The display apparatus of claim 2, wherein the blocking metal layer defines an opening corresponding to each transmission area.

4. The display apparatus of claim 3, wherein the opening has a circular shape in plan view.

5. The display apparatus of any one of claims 1 to 4, further comprising:
a first horizontal wiring crossing the first display area, and extending from the first display area to the second display area; and
a second horizontal wiring spaced from the first horizontal wiring, crossing the first display area, and extending from the first display area to the second display area,
wherein a width of a part of the second horizontal wiring is greater than a width of a part of the first horizontal wiring in plan view.

6. The display apparatus of claim 5, wherein the first horizontal wiring is electrically connected to a pixel circuit of at least one of the first light-emitting diodes and to a pixel circuit of at least one of the second light-emitting diodes.

7. The display apparatus of claim 5 or claim 6, wherein the second horizontal wiring comprises:
a first wiring portion extending in a first direction; and
a second wiring portion extending diagonally with respect to the first direction,
wherein a width of the first wiring portion is less than a width of the second wiring portion in plan view.

8. The display apparatus of any one of claims 5 to 7, wherein the first horizontal wiring and the second horizontal wiring are respectively at different layers.

9. The display apparatus of any one of claims 5 to 8, wherein a total resistance of the first horizontal wiring is substantially similar to a total resistance of the second horizontal wiring.

10. The display apparatus of any one of claims 5 to 9, wherein a width of the first horizontal wiring is substantially constant in plan view.

11. The display apparatus of any one of claims 5 to 10, wherein the second horizontal wiring is connected to a pixel circuit of at least one of the first light-emitting diodes.

12. A display apparatus comprising:
a first display area in which first light-emitting diodes are arranged;
a second display area at least partially surrounded by the first display area, and in which display element groups comprising second light-emitting diodes and transmission areas are arranged, at least one of the transmission areas having a circular shape;
a light-blocking insulating layer configured to define emission areas of the first light-emitting diodes and the second light-emitting diodes;
an anti-reflection layer above the light-blocking insulating layer, and comprising a light-blocking layer and color filters;
a first horizontal wiring crossing the first display area, and extending from the first display area to the second display area; and
a second horizontal wiring spaced apart from the first horizontal wiring, crossing the first display area, and extending from the display area to the second display area,
wherein a width of the second horizontal wiring varies in plan view, and
wherein a width of a part of the second horizontal wiring is greater than a width of a part of the first horizontal wiring in plan view.

13. The display apparatus of claim 12, wherein:
(i) the first horizontal wiring is electrically connected to a pixel circuit of at least one of the first light-emitting diodes, and to a pixel circuit of at least one of the second light-emitting diodes; and/or
(ii) the second horizontal wiring comprises:
a first wiring portion extending in a first direction; and
a second wiring portion extending diagonally with respect to the first direction,
wherein a width of the first wiring portion is less than a width of the second wiring portion in plan view.

14. The display apparatus of claim 12 or claim 13, wherein:
(i) the first horizontal wiring and the second horizontal wiring are respectively at different layers; and/or
(ii) a total resistance of the first horizontal wiring is substantially similar to a total resistance of the second horizontal wiring; and/or
(iii) a width of the first horizontal wiring is constant in plan view; and/or
(iv) the second horizontal wiring is connected to a pixel circuit of at least one of the first light-emitting diodes.

15. The display apparatus of any one of claims 12 to 14, further comprising a blocking metal layer in the second display area, and defining openings corresponding to the transmission areas, optionally wherein the opening has a circular shape in plan view.
